# EUROPEAN PATENT APPLICATION

(11) **EP 4 283 839 A1**
(43) Date of publication of application: **29.11.2023**
(21) Application number: 22174805.6
(22) Date of filing: 23.05.2022
(51) Int. Cl.: H02K 3/26, H02K 3/47, H02K 16/00

(54) **STATOR FOR A ROTARY ELECTRIC MACHINE, ROTARY ELECTRIC MACHINE AND HOUSEHOLD APPLIANCE**

(71) Applicant: BSH Hausgeräte GmbH, 81739 München (DE)
(72) Inventor: Schemmerer, Roman, 84088 Neufahrn i. NB (DE); Barbu, Mircea, 93049 Regensburg (DE); Gula, Martin, 08501 Badejov (SK)

(57) **Abstract**

Disclosed is a stator 10, 10', 10" for or of a rotary electric machine 1, 1', the stator configured as a PCB stator comprising a substrate 100 provided with one or more electrically conductive trace/s 110, 110', wherein the substrate is at least partially made of a substrate material comprising a thermoplast, a bio-based vitrimer and/or a bio-based thermoset.

Further disclosed are a rotary electric machine comprising a rotor and such stator, and a household appliance comprising such rotary electric machine.

## Description

The present invention concerns a stator for or of a rotary electric machine such as an electric motor or an electric generator. The invention further concerns a rotary electric machine with a stator, and a household appliance comprising such rotary electric machine.

Rotary electric machines comprising a rotor revolving adjacent to a stator are employed in a huge area of applications. The stator of such system may be a permanent magnet or an electric magnet. In the latter case, it is conventionally made of wire windings coiled around a ferromagnetic core. More recently, axial flux motors with printed circuit board stators (briefly "PCB stators") have been developed, the PCB stators comprising a substrate with copper windings printed thereon. Such stators are highly efficient and require far less volume and weight than the traditional ones providing for the same torque. Moreover, they produce less noise, are long-lasting, and allow an easily customised production by software configuration of the respective winding patterns.

It is an object of the present invention to provide a technique improving rotary electric machines and, in particular, household appliances comprising a rotary electric machine.

The object is achieved by a stator according to claim 1, by a rotary electric machine according to claim 9 and by a household appliance according to claim 10. Advantageous embodiments are disclosed in the dependent claims, the description and the figures.

A stator according to the present invention forms part of or is devised to form part of a rotary electric machine, such as an electric motor or an electric generator. The stator is configured as a PCB stator comprising a substrate provided with one or more electrically conductive trace/s. Therein, the substrate comprises a substrate material comprising a thermoplastic and/or a bio-based vitrimer and/or a bio-based thermoset; therein and in what follows, a material is denominated as "bio-based" if it is derived from renewable biological resources.

A rotary electric machine according to the present invention comprises a stator according to an embodiment of the present invention, and a rotor. It may in particular be an electric motor or an electric generator, and/or it may form part or be devised to form part of a household appliance, in particular a household appliance according to the present invention:
A household appliance according to the present invention comprises a rotary electric machine according to an embodiment of the present invention. For instance, the household appliance may be a kitchen appliance or a cleaning appliance. The rotary electric machine may be configured to drive a pump, or to move a tool of the household appliance. In particular, it may be configured to rotate a knife, one or more beater/s, a fan, or a drum of a washing machine, just to mention a few examples.

For printed circuit boards supporting electronic components, substrates of thermoplastic material have been found to have some advantages compared to the traditional ones. However, substrates of PCB stators are conventionally made of a glass reinforced epoxy laminate (in particular, FR4). Such PCB stators are questionable with regard to their environmental acceptability and safety, as they are usually made of toxic constituents and as they have to be burnt for disposal once they are decided to be discarded. By contrast, a thermoplastic is recyclable by remelting it, and a bio-based vitrimer as well as a bio-based thermoset can be produced with small impact on the environment. By using such material for a PCB stator, the present invention thus improves environmental sustainability. In respective embodiments, the bio-based vitrimer and/or the bio-based thermoset may preferably be bio-degradable.

Advantageously, in embodiments where the stator comprises a thermoplastic material, this material is or at least comprises a high-temperature thermoplastic, having a melting temperature of at least 150°C, preferably at least 200°C, more preferably at least 280°C.

According to advantageous embodiments of the present invention, the substrate is a laminate, i.e., it has a layered structure comprising multiple layers, at least one of which comprises said substrate material (comprising a thermoplastic, a bio-based vitrimer and/or a bio-based thermoset). In particular, said substrate material may be comprised by a first layer of such substrate, which may comprise at least one further layer. Such further layer may comprise a material associated with a same or another one of the material classes "thermoplastics", "bio-based vitrimers" and "bio-based thermosets" as/than said substrate material comprised by the first layer is associated with, or it may belong to a further (different) class of materials.

In particular, the substrate material of the first layer may comprise a thermoplastic, and the further layer may likewise comprise the (same) thermoplastic; thereby the substrate is particularly easy to be recycled. Alternatively, the further layer may comprise another thermoplastic material. Analogously, in respective embodiments, the further layer may comprise a same bio-based vitrimer or another bio-based vitrimer as/than the first layer does, or the further layer may comprise a same bio-based thermoset or another bio-based thermoset as/than the first layer does.

Alternatively, the first layer may comprise a thermoplastic, and the further layer may comprise a bio-based vitrimer or a bio-based thermoset. As a further alternative, the first layer may comprise a bio-based vitrimer, and the further layer may comprise a bio-based thermoset, for instance.

Preferably, in a plane extension of the substrate (i.e., in the directions of an x-axis and a y-axis of the substrate), said substrate material has a coefficient of thermal expansion (CTE) adjusted to copper with 16 and 20 ppm/K.

At least a part of said substrate material comprised by the substrate may have a density of at least 1 g/cm³, at least 1.3g/cm³ or even at least 1.5 g/cm³. Thereby, a particularly high durability can be achieved. In particular, at least a part of said substrate material (comprising the thermoplast, the bio-based vitrimer and/or the bio-based thermoset) may be solid (i.e., compact).

Additionally or alternatively, at least a part of the substrate material comprised by the substrate may be foamed. Such foamed material provides a particularly lightweight PCB stator. In particular, a density of such material may be at most 1.2 g/cm³ or even at most 0.9 g/cm³.

The said substrate material (comprising the thermoplastic, the bio-based vitrimer and/or the bio-based thermoset) of the substrate may be at least partially loaded with a filling material such as fibres and/or particles; in such cases, said substrate material may thus serve as a matrix material of the substrate. By such loading, a particularly stable stator can be achieved. In particular, in such embodiments, at least a part of the filling material may be derived from renewable biological resources. In particular, the filling material may include or even consist of biological fibres.

The electrically conductive trace/s of a stator according to the present invention, which trace/s in particular may comprise copper windings, may be at least partially built on a surface of the substrate and/or may be at least partially embedded in the substrate. In particular, the electrically conductive trace/s may be covered by at least one covering layer. Such covering layer may comprise the thermoplastic material and/or a further thermoplastic material.

In particular, the trace/s may be printed or etched on an even surface of the substrate or - in embodiments where the substrate is a laminate - on an even surface of a layer thereof.

For instance, in embodiments where the substrate has a layered structure as mentioned above, the said substrate material of one layer thereof may be foamed, and another layer of the substrate may comprise an unfoamed (solid) part. In such embodiments, the one or more electrically conductive trace/s may in particular be arranged on the other layer, e.g. printed and/or or etched on a surface thereof. Thereby, the foamed layer provides for a particular lightweight stator, while the unfoamed other layer may improve, due to its bubble-free structure, a precise structure of the electrically conductive trace/s.

According to advantageous embodiments, the substrate may be a first substrate, and the stator may comprise one or more further substrate/s respectively provided with one or more electrically conductive trace/s, the one or more further substrate/s at least partially made of a second substrate material associated with a same or another one of the material classes "thermoplastics", "bio-based vitrimers" and "bio-based thermosets" as/than said substrate material comprised by the first substrate is associated with. In particular, in respective embodiments, the further substrate/s may comprise the same and/or another thermoplastic material, the same and/or another bio-based vitrimer and/or the same and/or another bio-based thermoset as/than the first substrate does. Alternatively, the substrate material comprised by the first substrate may comprise a thermoplastic, while the second substrate may comprise a bio-based vitimer or a bio-based thermoset. As a further alternative, the substrate material of the first substrate may comprise a bio-based vitimer, while the second substrate may comprise a bio-based thermoset.

In particular, a rotary electric machine according to the present invention may be a multi-core rotary electric machine, comprising such stator with various substrates. The rotary electric machine may further comprise various rotors arranged adjacent and alternating (in axial direction with respect to a devised rotational axis of the rotary electric machine) with the various substrates. Such rotary electric machine may provide a particularly high power.

According to advantageous embodiments of the present invention, the stator has a diameter of at least 50mm, at least 70mm, at least 100mm or at least 150mm. Additionally or alternatively, a/the diameter of the stator may be at most 200mm or at most 160mm.

The rotor/s of a rotary electric machine according to the present invention may comprise a plurality of permanent magnets, such as at least 6, at least 8 or at least 10 permanent magnets.

In particular, a rotary electric machine according to the present invention may advantageously be developed for a power in the range from 5W to 300W.

In what follows, preferred embodiments of the present invention are explained with respect to the accompanying drawings. As is to be understood, the various elements and components are depicted as examples only, may be facultative and/or combined in a manner different than that depicted. Reference signs for related elements are used comprehensively and are not defined again for each figure.

Shown is schematically in
- Fig. 1a:: a first exemplary embodiment of a rotary electric machine according to the present invention in an exploded view;
- Fig. 1b:: a second exemplary embodiment of a rotary electric machine according to the present invention in another exploded view;
- Fig. 2:: a cross sectional view of a stator according to an exemplary embodiment of the present invention;
- Fig. 3a:: a single-core arrangement of a rotary electric machine according to an exemplary embodiment of the present invention; and
- Fig. 3b:: a dual-core arrangement of rotary electric machine according to an exemplary embodiment of the present invention.

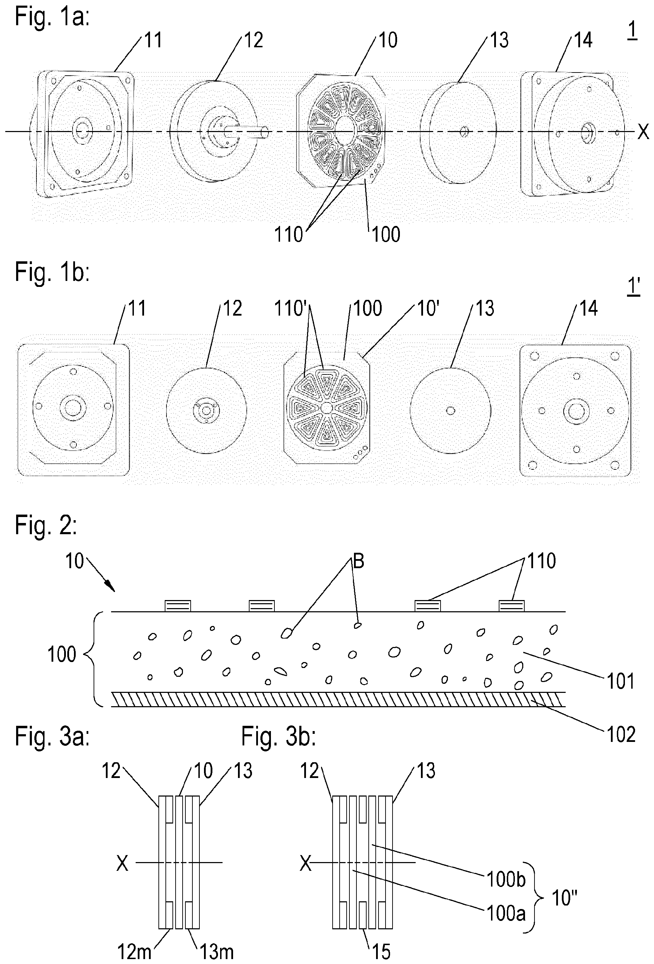

In Figure 1a, an exploded view of a rotary electric machine 1 according to an embodiment of the present invention is depicted as arranged along a devised axis X of rotation of the included rotors 12, 13. The rotary electric machine 1 comprises a stator 10 according to an exemplary embodiment of the present invention, the stator comprising a substrate 100 at least partially made of a substrate material comprising a thermoplastic and/or a bio-based vitrimer and/or a bio-based thermoset, and a plurality of electrically conductive traces, preferably copper windings. The rotors 12, 13 are arranged axially adjacent at each side of the stator 10. The rotors 12, 13 each comprise a plurality of permanent magnets (not visible in Figure 1a). A casing with components 11, 14 is configured to house both rotors12, 13 and the stator 10 from axially both sides.

Figure 1b shows a further exemplary rotary electric machine 1', wherein the single parts thereof are depicted with viewing direction along the devised axis of rotation. The rotary electric machine 1' comprises a casing with components 11, 14, two rotors 12, 13, and a stator 10' (with a substrate at least partially made of a substrate material comprising a thermoplastic and/or a bio-based vitrimer and/or a bio-based thermoset) which are arranged analogously to the casing, rotors and stator or the rotary electric machine 1 described above with respect to Figure 1a. Therein, the stator 10' has another number of electrically conductive traces than the stator 10 of rotary electric machine 1. Thereby, the rotary electric machines 1, 1' each are adapted to their respectively intended application, such as in a respective household appliance according to the present invention.

Figure 2 shows a portion of the stator 10 (shown in Figure 1a as included in the rotary electric machine 1) according to an exemplary embodiment of the present invention in a cross section. The stator 10 has a substrate 100 which in the present case is a laminate, i.e., it has a layered structure comprising layers 101, 102. A first layer 101 is provided with an electrically conductive trace 110, and is made of a substrate material comprising a thermoplastic and/or a bio-based vitrimer and/or a bio-based thermoset. Due to such substrate, the stator 10 has an improved environmental sustainability.

In the embodiment shown in Figure 2, the first layer 101 is made of a foamed substrate material trapping pockets B preferably filled with a gas.

Due to the foamed character of the layer 101, the stator 10 is considerably lighter than stators of the same size and performance which are made of conventional substrate material (in particular, FR4).

A second layer 102 of the substrate 100 covers a surface of the first layer, which surface is opposite to that where the electrically conductive traces are provided. Preferably, the second layer 102 comprises a layer material belonging to the class of thermoplastic materials, belonging to the class of bio-based vitrimers and/or belonging to the class of bio-based thermosets. Therein, the material class said layer material (of the second layer) is associated with may be the same as or a different than the class said substrate material (comprised by the first layer) is associated with. In case of coinciding classes, the layer material and the substrate material may coincide or may be different.

In the exemplary embodiment depicted in Figure 2, the second layer 102 is unfoamed, i.e., solid. It may improve rigidity of the substrate 100.

Figure 3a provides a schematic view of an arrangement of two rotors 12, 13 and a stator 10 (according to an embodiment of the present invention) of a rotary electric machine according to an exemplary embodiment, with radial viewing direction (orthogonal to the devised axis X of rotation of the rotors 12, 13). The rotors 12, 13 each comprise a plurality of permanent magnets 12m, 13m. As the stator 10 comprises only one substrate 100 with electrically conductive traces (not shown), Figure 3a shows a single-core arrangement.

By contrast, the stator 10" shown in Figure 3b comprises a stator 10" with two substrates 100a, 100b, which each are provided with electrically conductive traces (not shown) and comprise a (same or different) substrate material. Accordingly, Figure 3b shows a dual-core arrangement. The substrates 100a, 100b with their respective electrically conductive traces are arranged between rotors 12, 15 and 15, 13, respectively. As is to be understood, the stator according to the present invention may comprise further substrates with electrically conductive traces, where further rotors may be added to the arrangement, resulting in a triple-core arrangement or further multi-core arrangement.

Disclosed is a stator 10, 10', 10" for or of a rotary electric machine 1, 1', the stator configured as a PCB stator comprising a substrate 100 provided with one or more electrically conductive trace/s 110, 110', wherein the substrate is at least partially made of a substrate material comprising a thermoplastic, a bio-based vitrimer and/or a bio-based thermoset.

Further disclosed are a rotary electric machine comprising a rotor and such stator, and a household appliance comprising such rotary electric machine.

### Reference signs

- 1, 1': rotary electric machine

- 10, 10', 10": stator
- 11: component of casing
- 12: rotor
- 12m: permanent magnet
- 13: rotor
- 13m: permanent magnet
- 14: component of casing
- 15: rotor

- 100, 100a, 100b: substrate
- 101: layer
- 102: layer

- 110, 110': electrically conducting trace

- B: pocket in foamed layer
- X: devised axis of rotation

## Claims

1. Stator (10, 10', 10") for or of a rotary electric machine (1, 1'), the stator configured as a PCB stator comprising a substrate (100) provided with one or more electrically conductive trace/s (110, 110'), wherein the substrate (100) is at least partially made of a substrate material comprising a thermoplastic, a bio-based vitrimer and/or a bio-based thermoset.

2. Stator according to claim 1, wherein at least a part of said substrate material is foamed.

3. Stator according to one of claims 1 or 2, wherein said substrate material is at least partially loaded with a filling material such as fibres and/or particles.

4. Stator according to claim 3, wherein at least a part of the filling material is derived from renewable biological resources.

5. Stator according to one of the preceding claims, wherein said substrate material comprises a high-temperature thermoplastic.

6. Stator according to one of the preceding claims, wherein the substrate (100) has a layered structure, wherein at least one layer (101, 102) of the substrate comprises said substrate material.

7. Stator according to claim 6, wherein said substrate material is comprised by a first layer (101, 102) of the substrate (100), and the substrate (100) comprises at least one further layer comprising a layer material, wherein
- both the substrate material and the layer material comprise a same thermoplast or different thermoplasts;
- both the substrate material and the layer material comprise a same bio-based vitrimer or different bio-based vitrimers; or
- both the substrate material and the layer material comprise a same bio-based thermoset or different bio-based thermosets.

8. Stator according to one of the preceding claims, wherein the substrate is a first substrate (100a) and the stator comprises one or more further substrates (100b) respectively provided with one or more electrically conductive trace/s, the one or more further substrate/s (100b) at least partially made of a material which is associated with a same or another material class given by material classes "thermoplastics", "bio-based vitrimer" and "bio-based thermosets" as/than said substrate material of the first substrate is associated with.

9. Rotary electric machine (1, 1') comprising a rotor (12, 13, 15), and a stator (10, 10', 10") according to one of the preceding claims.

10. Household appliance comprising a rotary electric machine (1, 1') according to claim 9.
